# EUROPEAN PATENT APPLICATION

(11) **EP 2 249 383 A2**
(43) Date of publication of application: **10.11.2010**
(21) Application number: 10157757.5
(22) Date of filing: 25.03.2010
(51) Int. Cl.: H01L 23/433, H01L 23/373

(54) **Semiconductor apparatus and heat conductive sheet**

(30) Priority: 26.03.2009 JP 2009076680
(71) Applicant: Kabushiki Kaisha Toyota Jidoshokki, Kariya-shi, Aichi 448-8671 (JP); Toyota Jidosha Kabushiki Kaisha, Toyota-shi, Aichi 471-8571 (JP)
(72) Inventor: Suzuki, Sadanori, Kariya-shi Aichi 448-8671 (JP); Ozaki, Kiminori, Kariya-shi Aichi 448-8671 (JP); Koike, Yasuhiro, Kariya-shi Aichi 448-8671 (JP); Omiya, Yuji, Toyota-shi Aichi 471-8571 (JP)
(74) Representative: TBK-Patent

(57) **Abstract**

A semiconductor apparatus is comprising a circuit board (10) with a semiconductor device (20) surface-mounted on one surface thereof. A heatsink (30) is disposed and fixed with a connection member (40) and separated with a predetermined distance on one side of the circuit board (10) opposite to the surface where the semiconductor device (20) is mounted. A heat conductive sheet (50) is provided between the circuit board (10) and the heatsink (30) and thermally connecting the semiconductor device (20) and the heatsink (30) through the circuit board (10). The heat conductive sheet (50) is constituted as a laminate of a first member and a second member and one of the first and second members is a ceramic board (51) whereas the other is a resin sheet material (52) having highly heat conductive fillers mixed therein.

## Description

### BACKGROUND OF THE INVENTION

The present invention relates to a semiconductor apparatus and a heat conductive sheet.

As a structure for dissipating the heat emitted by semiconductor devices mounted on a circuit board to a heatsink, Japanese Patent Laid-Open No. H09-51187 describes a structure in which a metallic tab in thermal communication with a silicon integrated circuit is provided against the printed circuit board and a compressible pad is provided between this metallic tab and an aluminum housing. The electrically insulative but thermally conductive pad, when compressed between the metal tab and the aluminum housing, conducts (transfers) heat from the metal tab (electronic equipment) to the aluminum housing. The compressible pad also alleviates (absorbs) permissible assembly tolerances while electrically insulating the electronic equipment from the housing.

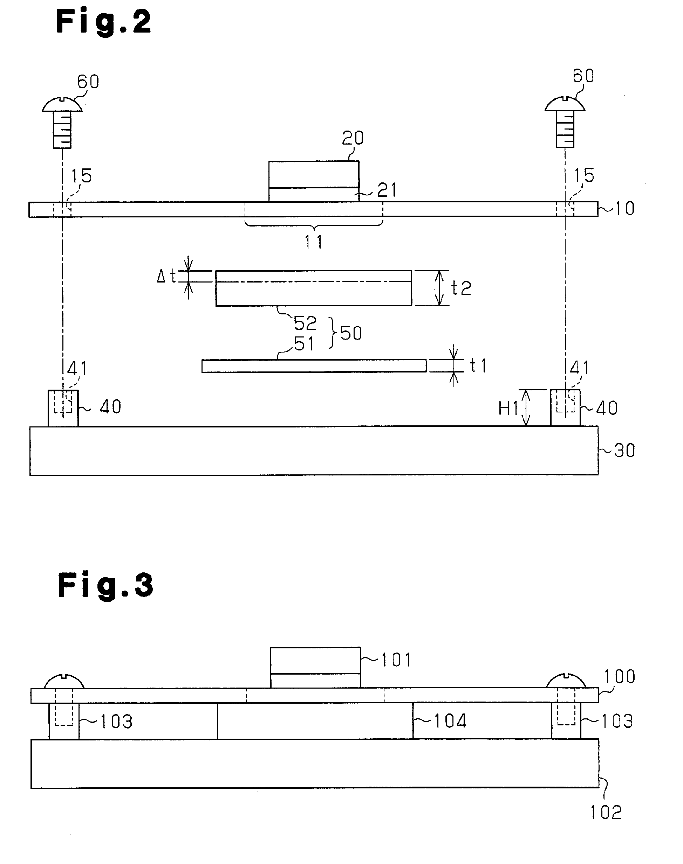

In addition, there is known a structure as shown in FIG. 3 for conducting the heat away that is generated by power devices, particularly SMDs (surface mounted devices), mounted on the board to the heatsink. In FIG. 3, a surface mount type semiconductor device 101 is mounted on a circuit board 100 and the circuit board 100 is screwed to a heatsink 102 separated with cylindrical members 103 as connection members therebetween and a heat conductive sheet 104 is provided between the heatsink 102 and the surface opposite to the side of the circuit board 100 on which the surface mount type semiconductor device 101 is mounted. The heat generated by the surface mount type semiconductor device 101 is transferred to the heatsink 102 through the circuit board 100 and the heat conductive sheet 104.

In such a structure, the heat conductive sheet 104 is required to have:
(1) High heat conductivity;
(2) Electrical insulation to ensure isolation between the circuit board 100 and the heatsink 102; and
(3) Elasticity to absorb tolerances when the circuit board 100 is screwed to the heatsink 102

### SUMMARY OF THE INVENTION

However, the heat conductive sheet 104 as a single member is difficult to satisfy all three requirements of high heat conductivity, electrical insulation and elasticity. For example, resins having electrical insulation and elasticity have low heat conductivity. When fillers of metal or carbon are incorporated in the resins to enhance the heat conductivity, electrical insulation deteriorates. When ceramics having high heat conductivity are used, sufficient electrical insulation can be achieved whereas elasticity is so poor that tolerances cannot be absorbed.

The present invention was arrived at in view of such circumstances, and an object thereof is to provide a semiconductor apparatus and a heat conductive sheet excellent in heat conductivity, electrical insulation and tolerance absorption (elasticity).

To achieve the foregoing objective and in accordance with one aspect of the prsent invention, a semiconductor apparatus including a semiconductor device, a circuit board, a heat sink, a connection member, and a heat condcutive sheet is provided. The circuit board has a mounting surface where the semiconductor device is mounted. The heatsink is located on a side of the circuit board opposite to the semiconductor device. The connection member fixes the heatsink to the circuit board with the heatsink separated from the circuit board by a predetermined distance. The heat conductive sheet is disposed between the circuit board and the heatsink. The semiconductor device is thermally connected to the heatsink through the circuit board and the heat conductive sheet. The heat conductive sheet includes a resin sheet material having a highly heat conductive filler mixed therein and a ceramic board. One of the ceramic board and the resin sheet material is a first member, and the other is a second member. The second member is laminated onto the first member.

In accordance with another aspect of the present invention, a semiconductor apparatus including a semiconductor device, a circuit board, a heatsink, a connection member, and a heat conductive sheet is provided. The semiconductor device is mounted is mounted on the circuit board. The heatsink is located on a side of the circuit board opposite to the semiconductor device. The connection member fixes the heatsink to the circuit board with the heatsink separated from the circuit board by a predetermined distance. The heat conductive sheet is disposed between the circuit board and the heatsink. The semiconductor device is thermally connected to the heatsink through the circuit board and the heat conductive sheet. The semiconductor apparatus includes a first member and a second member that is laminated onto the first member. The elasticity of the first member is higher than that of the second member. The electrical insulation of the second member is higher than that of the first member.

In accordance with yet another aspect of the present invention, a heat conductive sheet that conducts heat from a semiconductor device to a heatsink is provided. The heat conductive sheet includes a first member and a second member laminated onto the first member. One of the first member and the second member is a ceramic board, and the other is a resin sheet material having a highly heat conductive filler mixed therein.

### BRIEF DESCRIPTION OF THE DRAWINGS

FIG. 1 is a side view of an embodiment of a semiconductor apparatus in accordance with the present invention;
FIG. 2 is an exploded side view of an embodiment of a semiconductor apparatus in accordance with the present invention; and
FIG. 3 is a side view of a semiconductor apparatus to explain prior art.

### DETAILED DESCRIPTION OF PREFERRED EMBODIMENTS

Hereinbelow, an embodiment of a semiconductor apparatus in accordance with the present invention is described with reference to the attached drawings.

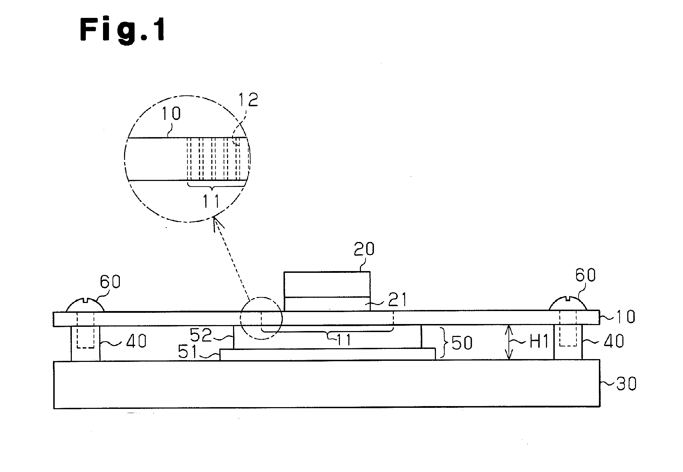

The semiconductor apparatus has a circuit board 10, a semiconductor device 20 and a heatsink 30 as shown in FIG. 1. The heatsink 30 also serves as part of a case.

The semiconductor device 20 is surface-mounted with solder 21 on the top surface (upper surface on one side) of the circuit board 10. The semiconductor device 20 is a power device such as an IGBT or a power MOSFET. A heat conductive area 11 (see FIG. 2) is formed on the disposing area of the semiconductor device 20 in the circuit board 10. As shown in FIG. 1, a number of through-holes 12 are provided in the heat conductive area 11, which also serves as an electrode area. The through-holes 12 are located adjacent to each other. These through-holes 12 are filled with metal (solder, copper, etc.). Heat emitted from the semiconductor device 20 mounted on the top surface of the circuit board 10 can thereby be conducted to the lower surface of the circuit board 10 through the heat conductive area 11. The heat conductive area 11 may be constituted of copper chips or the like embedded in the circuit board 10 in substitution for through-holes.

The heatsink 30 is made of aluminum. It may be made of copper as well as aluminum. Cylindrical members 40 as connection members are provided upright on the top surface of the heatsink 30. Specifically, cylindrical members 40 are arranged at positions corresponding to the four corners of the circuit board 10 which is made in a quadrilateral tabular form. A screw hole is respectively formed by threads along the inner circumferential surface of the cylindrical members 40 so that a screw 60 can be screwed therein. The cylindrical members 40 are formed integrally with the heatsink 30. The circuit board 10 is arranged on the top surface of the cylindrical members 40, and screws 60 penetrating the circuit board 10 are screwed into the inner circumferential surface of the cylindrical members 40. The circuit board 10 is thereby fixed with screws 60 to the heatsink 30.

The circuit board 10 is thereby disposed and fixed to the heatsink 30 with cylindrical members 40 (connection members) so that the heatsink 30 may be separated by a predetermined distance (height H1) from one side of the circuit board 10 opposite to the surface where the semiconductor device 20 is mounted. That is, the heatsink 30 is located on a side of the circuit board 10 opposite to the semiconductor device 20. The connection members 40 fix the heatsink 30 to the circuit board 10 with the heatsink 30 separated from the circuit board 10 by a predetermined distance.

In addition, a heat conductive sheet 50 is disposed between the circuit board 10 and the heatsink 30 in the disposing area (heat conductive area 11) for the semiconductor device 20 on the circuit board 10. This heat conductive sheet 50 is disposed between the circuit board 10 and the heatsink 30 in a state of being compressed and transformed. The semiconductor device 20 and the heatsink 30 are thermally connected (closely contacted) to each other through the circuit board 10 with the heat conductive sheet 50. That is, the semiconductor device 20 is thermally connected to the heatsink 30 through the circuit board 10 and the heat conductive sheet 50.

The heat conductive sheet 50 is constituted by laminating a ceramic board 51 as the first member and a resin sheet material 52 having fillers mixed therein as the second member. The resin sheet material 52 having fillers mixed therein is a resin sheet material which has highly heat conductive fillers mixed therein. Fillers of metals (for example, copper) and fillers of carbon are used as highly heat conductive fillers, and the heat conductivity is enhanced by mixing highly heat conductive fillers with a resin (for example, silicone resin).

The ceramic board 51 is made of aluminum nitride (AIN) having high heat conductivity and electrical insulation. Of the ceramic board 51 and the resin sheet material 52 having fillers mixed therein, the ceramic board 51 is disposed on the side of the heatsink 30 whereas the resin sheet material 52 having fillers mixed therein is disposed on the side of the circuit board 10. That is, the resin sheet material 52 and the ceramic board 51 are sequentially disposed from the circuit board 10 toward the heatsink 30. In addition, the projected area of the ceramic board 51 onto the heatsink 30 is larger than the projected area of the resin sheet material 52 having fillers mixed therein onto the heatsink 30. That is, the projected area of the heatsink-side member 51 onto the heatsink 30 is larger than the projected area of the circuit-board-side member 52 onto the heatsink 30. Furthermore, the projected area of the resin sheet material 52 having fillers mixed therein onto the heatsink 30 is larger than the area of the heat conductive area 11 of the circuit board 10. In this way, the resin sheet material 52 having fillers mixed therein having a larger area than the heat conductive area 11 is disposed under the heat conductive area 11 of the circuit board 10 whereas the ceramic board 51 having a larger area than the resin sheet material 52 having fillers mixed therein is disposed under the resin sheet material 52 having fillers mixed therein.

Assembly of the semiconductor apparatus is performed as follows.

The ceramic board 51 and the resin sheet material 52 having fillers mixed therein are sequentially disposed (laminated) on the heatsink 30 as shown in FIG. 2. Furthermore, the circuit board 10 on which the semiconductor device 20 is mounted is placed on the heatsink 30, and screws 60 are screwed into the cylindrical members 40 through through-holes 15 of the circuit board 10. The ceramic board 51 and the resin sheet material 52 having fillers mixed therein are thereby installed in a lamination state between the circuit board 10 and the heatsink 30 in such a state as the resin sheet material 52 having fillers mixed therein being squeezed and elastically deformed. That is, the sum (= t1 + t2) of the thickness t1 of the ceramic board 51 and the thickness t2 of the resin sheet material 52 having fillers mixed therein is larger than the height H1 of the cylindrical members 40 in the state before the installation, which is shown in FIG. 2. When the assembly is performed from the state of FIG. 2, the resin sheet material 52 having fillers mixed therein is squeezed (compressed) so that the thickness thereof reduces by a predetermined amount Δt as shown in FIG. 1.

Both the ceramic board 51 and the resin sheet material 52 having fillers mixed therein are excellent in heat conductivity and the resin sheet material 52 having fillers mixed therein assumes a role of tolerance absorption. The ceramic board 51 takes on the role of ensuring electrical insulation.

Therefore, all the functions of heat conductivity, electrical insulation and tolerance absorption requirements can be achieved by using the heat conductive sheet 50 of this embodiment.

The tolerance absorption is described specifically as follows.

The height H1 of the cylindrical members 40 has a central value of 3 mm with a tolerance of ±0.2 mm (i.e., 3±0.2 mm). The thickness t1 of the ceramic board 51 has a central value of 1 mm with a tolerance of ±0.1 mm (i.e., 1±0.1 mm). The circuit board 10 and the heat conductive sheet 50 should be closely contacted with each other to conduct heat efficiently.

For example, when the height H1 of the cylindrical members 40 is the maximum (3.2 mm) and the thickness t1 of the ceramic board 51 is minimum (0.9 mm), the distance (H1 - t1) between the circuit board 10 and the ceramic board 51 is 2.3 mm. Therefore, the circuit board 10 and the heat conductive sheet 50 can closely contact each other when the thickness t2 of the resin sheet material 52 having fillers mixed therein is larger than 2.3 mm. When the thickness t2 of the resin sheet material 52 having fillers mixed therein is larger than 2.3 mm, the resin sheet material 52 having fillers mixed therein, which has elasticity, is squeezed (compressed) so that the thickness thereof reduces by a predetermined amount Δt and the circuit board 10 and the resin sheet material 52 having fillers mixed therein (heat conductive sheet 50) can closely contact each other.

When the height H1 of the cylindrical members 40 is the minimum (2.8 mm) and the thickness t1 of the ceramic board 51 is maximum (1.1 mm), the distance (H1 - t1) between the circuit board 10 and the ceramic board 51 is 1.7 mm. Although the thickness t2 of the resin sheet material 52 having fillers mixed therein is 2.3 mm or more as mentioned above, the resin sheet material 52 having fillers mixed therein, which has elasticity, is squeezed (compressed) so that the thickness thereof reduces by a predetermined amount Δt and thereby the circuit board 10 and the resin sheet material 52 having fillers mixed therein (heat conductive sheet 50) can closely contact each other.

As described above, the distance (H1-t1) between the circuit board 10 and the ceramic board 51 may vary depending on the tolerances of the cylindrical members 40 and the ceramic board 51, and therefore, the heat conductive sheet 50 should absorb the tolerance for allowing the circuit board 10 and the heat conductive sheet 50 to closely contact each other. Since the resin sheet material 52 having fillers mixed therein is excellent in elasticity, the heat conductive sheet 50 of these embodiments can absorb tolerance.

In addition, even if the circuit board 10 is bent when the circuit board 10 is screwed and fixed to the heatsink 30, the resin sheet material 52 having fillers mixed therein is excellent in elasticity, and therefore, hardly any gap is caused between the circuit board 10 and the heat conductive sheet 50, and additionally, breakage of the circuit board 10 can be prevented.

According to the embodiment described above, the following advantages are obtained.
(1) The heat conductive sheet 50 is constituted by laminating the first member (51) and the second member (52) and one of the first member and the second member is a ceramic board 51 and the other is a resin sheet material 52 having fillers mixed therein (resin sheet material in which highly heat conductive fillers are mixed). The ceramic board 51 is excellent in electrical insulation and heat conductivity but poor in elasticity whereas the resin sheet material 52 having fillers mixed therein is excellent in elasticity and heat conductivity but poor in electrical insulation. The heat conductive sheet 50 constituted as a laminate of both is excellent in electrical insulation, heat conductivity and elasticity. In this way, it is not a heat conductive sheet constituted of a single member that takes all the roles of electrical insulation, heat conductivity and tolerance absorption (elasticity) but a laminate of two members that can achieve the required functions. As a result, a semiconductor apparatus excellent in heat conductivity, electrical insulation and tolerance absorption (elasticity) can be provided by a semiconductor apparatus in which a surface-mounted semiconductor device 20 is thermally connected to the heatsink 30 through the circuit board 10 and the heat conductive sheet 50.

When the ceramic board 51 is the first member and the resin sheet material 52 having fillers mixed therein is the second member, the heat conductive sheet 50 is constituted by laminating the first member (51) and the second member (52), and the electrical insulation of the first member (51) is higher than the electrical insulation of the second member (52), and the elasticity of the second member (52) is higher than the elasticity of the first member (51). Thus, it is not a heat conductive sheet constituted of a single member that takes all the roles of electrical insulation, heat conductivity and tolerance absorption (elasticity) but a laminate of two members that can achieve the required functions.

For example, Young's modulus may be an index of elasticity, and the electric resistance may be an index of the electrical insulation. That is, whether it is excellent in elasticity or not can be compared, for example, using Young's modulus as an index and whether it is excellent in electrical insulation or not can be compared, for example, using electrical resistance as an index.
(2) The ceramic board 51 is disposed on the side of the heatsink 30 and the resin sheet material 52 having fillers mixed therein is disposed on the side of the circuit board 10. In a case where the resin sheet material 52 having fillers mixed therein is disposed on the side of the heatsink 30 and the ceramic board 51 is disposed on the side of the circuit board 10, and if the circuit board 10 bends, a gap may be formed between the ceramic board 51 and the circuit board 10 and thus heat radiation characteristics are liable to deteriorate. In contrast, when the ceramic board 51 is disposed on the side of the heatsink 30 and the resin sheet material 52 having fillers mixed therein is disposed on the side of the circuit board 10 as in the present embodiment, even if the circuit board 10 bends, hardly any gap is caused between the resin sheet material 52 having fillers mixed therein and the circuit board 10, and the circuit board 10 is maintained in close contact with the resin sheet material 52 having fillers mixed therein, which is preferable in ensuring proper heat radiation characteristics.
(3) Of the first member and the second member, the area projected onto the heatsink 30 of the ceramic board 51, which is a member disposed on the side of the heatsink 30, is made larger than the area projected onto the heatsink 30 of the resin sheet material 52 having fillers mixed therein, which is a member disposed on the side of the circuit board 10. Therefore, since the heat flow from the semiconductor device 20 widens as it is on the lower side (on the downstream side) in the heat radiation path, it can be made easier to conduct heat to the heatsink 30. In addition, since the ceramic board 51 positioned on the lower side is larger than the resin sheet material 52 having fillers mixed therein of the upper part, the structure is stable and easier to assemble.

The embodiments are not limited to the above but may be embodied, for example, as follows.

In the heat conductive sheet 50 of the above embodiment, the ceramic board 51 is disposed on the side of the heatsink 30 and the resin sheet material (resin sheet material in which highly heat conductive fillers are mixed therein) 52 is disposed on the side of the circuit board 10. But to the contrary, the ceramic board 51 may be disposed on the side of the circuit board 10 and the resin sheet material 52 having fillers mixed therein may be disposed on the side of the heatsink 30.

In the heat conductive sheet 50 of the above embodiment, the area projected onto the heatsink 30 of the member disposed on the side of the heatsink 30 (ceramic board 51) is made larger than the area projected onto the heatsink 30 of the member disposed on the side of the circuit board 10 (resin sheet material 52 having fillers mixed therein). But to the contrary, the area projected onto the heatsink 30 of the member disposed on the side of the heatsink 30 is made smaller than the area projected onto the heatsink 30 of the member disposed on the side of the circuit board 10. Alternatively, the area of the member disposed on the side of the heatsink 30 and the area of the member disposed on the side of the circuit board 10 may be made the same size (the same as the area projected onto the heatsink 30).

The ceramic board 51 may be formed of aluminum oxide (Al₂O₃), silicon nitride (Si₃N₄), or silicon oxide (SiO₂) as well as aluminum nitride (AlN).

A semiconductor apparatus is comprising a circuit board (10) with a semiconductor device (20) surface-mounted on one surface thereof. A heatsink (30) is disposed and fixed with a connection member (40) and separated with a predetermined distance on one side of the circuit board (10) opposite to the surface where the semiconductor device (20) is mounted. A heat conductive sheet (50) is provided between the circuit board (10) and the heatsink (30) and thermally connecting the semiconductor device (20) and the heatsink (30) through the circuit board (10). The heat conductive sheet (50) is constituted as a laminate of a first member and a second member and one of the first and second members is a ceramic board (51) whereas the other is a resin sheet material (52) having highly heat conductive fillers mixed therein.

## Claims

1. A semiconductor apparatus comprising:
a semiconductor device (20);
a circuit board (10) having a mounting surface where the semiconductor device (20) is mounted;
a heatsink (30) located on a side of the circuit board (10) opposite to the semiconductor device (20);
a connection member (40) that fixes the heatsink (30) to the circuit board (10) with the heatsink (30) separated from the circuit board (10) by a predetermined distance; and
a heat conductive sheet (50) disposed between the circuit board (10) and the heatsink (30), the semiconductor device (20) being thermally connected to the heatsink (30) through the circuit board (10) and the heat conductive sheet (50),
the semiconductor apparatus being **characterized in that** the heat conductive sheet (50) includes a resin sheet material (52) having a highly heat conductive filler mixed therein and a ceramic board (51),
wherein one of the ceramic board (51) and the resin sheet material (52) is a first member, and the other is a second member, and
wherein the second member is laminated onto the first member.

2. The semiconductor apparatus according to claim 1, **characterized in that** the resin sheet material (52) and the ceramic board (51) are sequentially disposed from the circuit board (10) toward the heatsink (30).

3. A semiconductor apparatus comprising:
a semiconductor device (20);
a circuit board (10) on which the semiconductor device (20) is mounted;
a heatsink (30) located on a side of the circuit board (10) opposite to the semiconductor device (20);
a connection member (40) that fixes the heatsink (30) to the circuit board (10) with the heatsink (30) separated from the circuit board (10) by a predetermined distance; and
a heat conductive sheet (50) disposed between the circuit board (10) and the heatsink (30), the semiconductor device (20) being thermally connected to the heatsink (30) through the circuit board (10) and the heat conductive sheet (50),
the semiconductor apparatus being **characterized in that** the heat conductive sheet (50) includes a first member and a second member that is laminated onto the first member,
wherein the electrical insulation of the first member (51) is higher than that of the second member (52), and
wherein the elasticity of the second member (52) is higher than that of the first member (51).

4. The semiconductor apparatus according to any one of claims 1 to 3, **characterized in that** one of the first member and the second member is a circuit-board-side member that is located close to the circuit board (10), and the other is a heatsink-side member that is located close to the heatsink (30), and
wherein the projected area of the heatsink-side member (51) onto the heatsink (30) is larger than the projected area of the circuit-board-side member (52) onto the heatsink (30).

5. A heat conductive sheet (50) that conducts heat from a semiconductor device (20) to a heatsink (30), the heat conductive sheet (50) comprising:
a first member; and
a second member laminated onto the first member,
the heat conductive sheet (50) being **characterized in that** one of the first member and the second member is a ceramic board (51), and the other is a resin sheet material having a highly heat conductive filler mixed therein.
